# DEMANDE DE BREVET EUROPEEN

(11) **EP 4 571 814 A1**
(43) Date de publication de la demande: **18.06.2025**
(21) Numéro de dépôt: 24219741.6
(22) Date de dépôt: 13.12.2024
(51) Int. Cl.: H01L 21/02, H10D 1/68, H01L 21/311

(54) **PROCEDE DE PREPARATION D'UN DISPOSITIF MULTICOUCHES ANTI-FERROELECTRIQUE**

(30) Priorité: 15.12.2023 FR 2314316
(71) Demandeur: Commissariat à l'Energie Atomique et aux Energies Alternatives, 75015 Paris (FR)
(72) Inventeur: MALLMANN TONELLI, Amanda, 38054 GRENOBLE (FR); BEDJAOUI, Messaoud, 38054 GRENOBLE (FR); GRENOUILLET, Laurent, 38054 GRENOBLE (FR); JOUSSEAUME, Vincent, 38054 GRENOBLE (FR)
(74) Mandataire: Gevers & Orès

(57) **Abrégé**

La présente invention concerne un procédé de préparation d'un dispositif multicouche anti-ferroélectrique, notamment ultrafin, comprenant une alternance d'au moins une couche d'un premier type et d'au moins une couche d'un deuxième type.

## Description

La présente invention concerne un procédé de préparation d'un dispositif multicouche anti-ferroélectrique, notamment ultrafin, comprenant une alternance d'au moins une couche d'un premier type et d'au moins une couche d'un deuxième type.

L'avènement des applications microélectroniques, nanoélectroniques et optroniques faisant appel à l'internet des objets a instauré une course effrénée pour la fabrication de circuits intégrés de plus en plus complexes.

Les critères de base de ces nouveaux dispositifs sont leurs très fortes intégrabilités, une compatibilité avec la technologie complémentaire métal-oxyde-semi-conducteur (CMOS) conjuguées avec une très faible consommation d'énergie.

Pour répondre à ces exigences, le recours à des matériaux avancés évolutifs en termes d'épaisseurs et de performances dans la construction et la fabrication de ces dispositifs est devenu primordial. Parmi les matériaux utilisables dans ce type de dispositifs microélectroniques, il y a la famille des matériaux dits anti-ferroélectriques (AF). Les matériaux et les couches anti-ferroélectriques AF sont des matériaux pyroélectriques possédant une classe cristallographique non-centrosymétrique. D'un point de vue macroscopique, les matériaux AF forment un sous ensemble de cristaux anti-polaires contrairement aux matériaux ferroélectriques qui forment un seul sous-ensemble des cristaux polaires. L'expression expérimentale d'un comportement anti-ferroélectrique est un double cycle d'hystérésis de la polarisation en fonction du champ électrique. D'un point de vue structural, la maille élémentaire des matériaux AF est généralement caractérisé par la dominance d'une phase cristallographique tétragonale.

D'un point de vue applicatif et contrairement aux matériaux ferroélectriques où l'engouement a fortement augmenté depuis la découverte de la ferroélectricité dans les couches ultraminces d'oxyde d'hafnium HfO2 en 2011, l'usage des matériaux anti-ferroélectriques en couches minces (<100nm) reste limité. Dans la pratique, il est possible d'utiliser des empilements MIM (Métal-Isolant-Métal) intégrant une couche anti-ferroélectrique faisant office de diélectrique isolant de haute permittivité comme dispositif de stockage d'énergie. Ce cas correspond à des structures type « MAFM » pour Métal-Anti Ferroélectrique-Métal. Dans certaines configurations, il est possible d'utiliser les couches anti-ferroélectriques AF pour la fabrication des capacitances à très haute densité en couplage avec les transistors pour des applications de mémoires embarquées type DRAM (pour Dynamic Random Access Memory).

Au cours des dernières années, plusieurs développements ont introduit des couches anti-ferroélectriques AF dans la réalisation d'un certain nombre de ces dispositifs. Néanmoins, les dispositifs proposés emploient des couches AF avec des épaisseurs généralement supérieures à des valeurs critiques (8 à 10 nm) au risque de dégrader les propriétés anti-ferroélectriques. Cette limitation en épaisseur réduit le champ d'application des couches anti-ferroélectriques dans dispositifs comme les grilles pour les transistors noeuds avancés ou la fabrication des capacitances de stockage d'énergie à très forte densité dans des substrats à très forte topographie.

Or dans le cas d'une couche diélectrique dont la composition physico-chimique et structurale est uniforme et homogène, la réduction de l'épaisseur de ladite couche à vocation anti-ferroélectrique s'accompagne par une augmentation du budget thermique global au-delà de 500°C afin de garantir la formation de la phase cristallographique nécessaire pour adjuger les propriétés anti-ferroélectriques à la capacitance fabriquée. Et cette augmentation du budget thermique global au-delà de 500°C n'est pas compatible avec l'exigence du budget thermique pour les procédés BEOL (pour Back End Of Line) dont les températures maximales admises sont inférieures à 450°C.

L'invention a pour but de permettre la mise en oeuvre d'une méthode de préparation d'un dispositif anti-ferroélectrique qui évite les inconvénients précités.

Ainsi, un but de l'invention est de fournir une méthode de préparation d'un dispositif anti-ferroélectrique, notamment ultrafin, tout en permettant la préservation d'un budget thermique compatible avec la technologie BEOL.

Un but plus particulier de l'invention est de fournir une méthode de préparation d'un dispositif anti-ferroélectrique autorisant une réduction de l'épaisseur des couches anti-ferroélectriques « AF » dans un empilement de capacitance type « MAFM », tout en permettant la préservation d'un budget thermique compatible avec la technologie BEOL.

Ainsi, selon un premier aspect, l'invention concerne un procédé de préparation d'un dispositif multicouche M anti-ferroélectrique à n couches, n étant supérieur ou égal à 2, constitué de ou comprenant une alternance d'au moins une couche A et d'au moins une couche B, ladite au moins une couche A étant, indépendamment, constituée de ou comprenant un composé choisi parmi les oxydes de zirconium (ZrO₂), les oxydes d'hafnium et de zirconium (HZO) enrichis en zirconium et les pérovskites,
ladite au moins une couche B étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ledit procédé comprenant les étapes suivantes :
   **(i)** une étape de préparation sur un substrat ou une électrode métallique inférieure d'un dispositif multicouches M' à n' couches, n' étant supérieur ou égal à 3, comprenant une alternance desdites couches A et B, la première des n' couches, au contact de l'électrode métallique inférieure, étant une couche A,
   **(ii)** une étape de dépôt sur ledit dispositif multicouches M' obtenu à l'issue de l'étape (i), à l'opposé de ladite électrode métallique inférieure, d'une électrode métallique supérieure,
   **(iii)** une étape de recuit du dispositif obtenu à l'issue de l'étape (ii),
   **(iv)** une étape de retrait de l'électrode métallique supérieure du dispositif obtenu à l'issue de l'étape (iii),
   **(v)** une gravure sélective des n' - n couches supérieures, à l'opposé de l'électrode métallique inférieure, notamment totale, pour obtenir sur ladite l'électrode métallique inférieure le dispositif multicouches M,
   **(vi)** optionnellement, une étape de dépôt sur ledit dispositif multicouches M' obtenu à l'issue de l'étape (v), à l'opposé de ladite électrode métallique inférieure, d'une électrode métallique supérieure.

Selon un autre aspect, l'invention concerne un procédé de préparation d'un dispositif multicouches M anti-ferroélectrique à n couches, n étant compris de 2 à 100, préférentiellement compris de 2 à 25, constitué de ou comprenant une alternance d'au moins une couche A et d'au moins une couche B, ladite au moins une couche A étant, indépendamment, constituée de ou comprenant un composé choisi parmi les oxydes de zirconium (ZrO₂), les oxydes d'hafnium et de zirconium (HZO) enrichis en zirconium et les pérovskites,
ladite au moins une couche B étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ledit procédé comprenant les étapes suivantes :
   **(i)** une étape de préparation sur un substrat ou une électrode métallique inférieure d'un dispositif multicouche M' à n' couches, n' étant compris de 3 à 101, avec n' > n, préférentiellement compris entre 3 et 26, comprenant une alternance desdites couches A et B, la première des n' couches, au contact de l'électrode métallique inférieure, étant une couche A,
   **(ii)** une étape de dépôt sur ledit dispositif multicouche M' obtenu à l'issue de l'étape (i), à l'opposé de ladite électrode métallique inférieure, d'une électrode métallique supérieure,
   **(iii)** une étape de recuit du dispositif obtenu à l'issue de l'étape (ii),
   **(iv)** une étape de retrait de l'électrode métallique supérieure du dispositif obtenu à l'issue de l'étape (iii),
   **(v)** une gravure sélective des n' - n couches supérieures, à l'opposé de l'électrode métallique inférieure, notamment totale, pour obtenir sur ladite l'électrode métallique inférieure le dispositif multicouches M,
   **(vi)** optionnellement, une étape de dépôt sur ledit dispositif multicouches M' obtenu à l'issue de l'étape (v), à l'opposé de ladite électrode métallique inférieure, d'une électrode métallique supérieure.

Selon un mode de réalisation particulier, ledit procédé comprend les étapes suivantes :
**(i)** une étape de préparation sur un substrat ou une électrode métallique inférieure d'un dispositif multicouches M' à n' couches, n' étant compris de 3 à 101, avec n' > n, préférentiellement compris entre 3 et 26, comprenant une alternance desdites couches A et B, la première des n' couches, au contact de l'électrode métallique inférieure, étant une couche A,
**(ii)** une étape de dépôt sur ledit dispositif multicouches M' obtenu à l'issue de l'étape (i), à l'opposé de ladite électrode métallique inférieure, d'une électrode métallique supérieure,
**(iii)** une étape de recuit du dispositif obtenu à l'issue de l'étape (ii),
**(iv)** une étape de retrait de l'électrode métallique supérieure du dispositif obtenu à l'issue de l'étape (iii),
**(v)** une gravure sélective des n' - n couches supérieures, à l'opposé de l'électrode métallique inférieure, notamment totale, pour obtenir sur ladite l'électrode métallique inférieure le dispositif multicouches M,
**(vi)** une étape de dépôt sur ledit dispositif multicouches M' obtenu à l'issue de l'étape (v), à l'opposé de ladite électrode métallique inférieure, d'une électrode métallique supérieure.

Par « oxydes d'hafnium et de zirconium (HZO) enrichis en zirconium », on entend en particulier les oxydes d'hafnium et de zirconium comprenant plus de 50%at (concentration atomique) de ZrO₂.

Parmi les pérovskites, on peut par exemple citer le zirconate de plomb (PbZrO₃), et l'hafniate de plomb (PbHfO₃).

Parmi les pérovskites, on peut par exemple citer le zirconate de plomb (PbZrO₃), l'hafniate de plomb (PbHfO₃), les pérovskites de type PZT/PZO pour Pb(Zr, Ti)O₃, les titanates de baryum et de strontium (BST), et les pérovskites exemptes de plomb (par exemple LNO pour LiNbO₃, BFO pour BiFeO₃, NBT pour Na_{0.5}Bi_{0.5}TiO₃)

Par « oxydes d'hafnium et de zirconium (HZO) enrichis en hafnium », on entend en particulier les oxydes d'hafnium et de zirconium comprenant plus de 50%at de HfO₂.

Par « oxydes d'hafnium et de zirconium (HZO) dopés en aluminium », on entend en particulier les oxydes d'hafnium et de zirconium comprenant de 0,1 à 10%at, de préférence 1%at environ, de Al₂O₃.

Par « oxydes d'hafnium et de zirconium (HZO) dopés en lanthane », on entend en particulier les oxydes d'hafnium et de zirconium comprenant de 0,1 à 10%at, de préférence 1%at environ, de lanthane.

Par « oxydes d'hafnium et de zirconium (HZO) dopés en gadolinium », on entend en particulier les oxydes d'hafnium et de zirconium comprenant de 0,1 à 10%at, de préférence 1%at environ, de gadolinium.

Par « oxydes d'hafnium et de zirconium (HZO) dopés en yttrium », on entend en particulier les oxydes d'hafnium et de zirconium comprenant de 0,1 à 10%at, de préférence 1%at environ, d'yttrium.

Par « oxydes d'hafnium et de zirconium (HZO) dopés en silicium », on entend en particulier les oxydes d'hafnium et de zirconium comprenant de 0,1 à 10%at, de préférence 1%at environ, de SiO₂.

Par « oxydes d'hafnium dopé en silicium (HSO) », on entend en particulier les oxydes d'hafnium comprenant de 0,1 à 10%at, de préférence 1%at environ, de SiO₂.

Par « dispositif multicouche M anti-ferroélectrique », on entend en particulier que le dispositif multicouche, est, lorsque considéré dans son ensemble, anti-ferroélectrique. Le dispositif est ainsi globalement anti-ferroélectrique, même si ce n'est pas nécessairement le cas de toutes les couches dudit dispositif.

De manière surprenante, il a d'ailleurs été mis en lumière que le dispositif multicouche M est anti-ferroélectrique, et ce, malgré la présence de couches qui peuvent ne pas être anti-ferroélectriques, voire être ferroélectriques.

Et de façon tout aussi surprenante, la nature et la position des couches A et B telles que définies précédemment permet d' obtenir de façon certaine et bien définie un dispositif multicouche anti-ferroélectrique.

Sans vouloir se restreindre à une quelconque théorie, le recuit permet de favoriser la formation d'une phase cristallographique à dominance tétragonale pour la couche unitaire A et à dominance monoclinique pour la couche unitaire B.

Et de façon critique, pour obtenir ledit dispositif M final sans passer par l'étape de gravure des couches supérieures (c'est-à-dire avec un recuit du nombre désiré de couches initiales), il serait nécessaire d'effectuer l'étape de recuit à environ 800°C, ce qui est incompatible avec les composants déjà présents sur le substrat. La réalisation d'un nombre supérieur de couches (empilement M') permet de faire un recuit à une température bien plus basse, par exemple à environ 400°C, ce qui est parfaitement compatible avec les composants déjà présents sur le substrat.

Ainsi, la structure, les propriétés et la nature même des couches du dispositif multicouches tel qu'obtenu à l'issue du procédé de l'invention diffèrent totalement de celle d'un empilement de couches (A/B)ₙ avec n ≥1, en particulier de par leur nature cristallographique. Et il en est de même du dispositif après gravure, par rapport à un ensemble de couches (A/B) initiales, diminué arbitrairement des couches correspondant à celles gravées.

Pour les raisons qui précèdent, la fonction (et donc l'intérêt) de la gravure sélective telle que définie dans le cadre de la présente invention est complètement différente de ce que pourrait être la simple gravure de monocouches A/B.

Par « anti-ferroélectrique », on entend en particulier un dispositif qui présente des moments dipolaires antiparallèles. Le cycle d'hystérésis est pour ce type de matériaux typiquement, et par définition, extrêmement rétrécis.

La mesure directe de l'anti-ferroélectricité d'un matériau consiste généralement à électriquement exciter le matériau à caractériser imbriqué entre deux électrodes pour mettre en évidence la présence et les caractéristiques d'un cycle d'hystérésis.

Par « une couche A (ou B) étant, indépendamment, constituée de ou comprenant... », on entend en particulier que les couches A peuvent être différentes les unes des autres, tout en étant toujours constituée de ou comprenant un composé choisi parmi le groupe défini précédemment. Selon un mode de réalisation particulier, les couches A (lorsqu'il y en a plus d'une) et/ou les couches B (lorsqu'il y en a plus d'une) sont constituées de ou comprennent un même composé tel que défini précédemment.

Ainsi, le dispositif M, après l'étape (iii) et après l'étape (vi), lorsque l'étape (vi) est réalisée, correspond à un dispositif MAFM (pour « Métal Anti-Ferroélectrique Métal»), dont la préparation consiste à déposer un matériau multicouche anti-ferroélectrique, notamment par ALD, entre deux électrodes métalliques.

Selon un mode de réalisation particulier, n est compris de 2 à 25, notamment de 2 à 20, n étant par exemple de 3.

Selon un mode de réalisation particulier, n'est compris de 3 à 26, notamment de 3 à 21, n' étant par exemple de 5.

Selon un mode de réalisation particulier, la dernière couche du dispositif multicouches M est une couche A.

Par « dernière couche du dispositif multicouches M », on entend en particulier la couche la plus éloignée du substrat ou de l'électrode métallique inférieure.

Selon un mode de réalisation particulier, le substrat est un substrat constitué de ou comprenant du silicium.

Selon un mode de réalisation particulier, le dispositif multicouche M' est préparé par dépôts successifs des couches A et B, en particulier par une technique de dépôt de couche atomique (ALD).

La technique de dépôt de couche atomique est susceptible de pouvoir développer des couches minces conformes, homogènes tout en en contrôlant l'épaisseur avec une précision inférieure au nanomètre.

Typiquement, le processus ALD commence par inonder la chambre de réaction avec un précurseur qui recouvre (ou « adsorbe ») la surface exposée du substrat. Ce processus est appelé autolimitatif car le précurseur ne peut s'adsorber que sur les zones exposées ; une fois que tous ceux-ci sont recouverts, l'adsorption s'arrête. Un deuxième gaz est ensuite introduit et réagit avec le précurseur pour former le matériau souhaité. Cette deuxième étape est également auto-limitée : une fois les sites précurseurs disponibles épuisés, la réaction s'arrête. Les deux étapes sont répétées jusqu'à obtenir l'épaisseur de film souhaitée. Le taux de croissance est généralement quantifié par la croissance par cycle (GPC : « growth per cycle »). Le cycle ALD typique se compose de deux demi-cycles, de doses séquentielles de précurseur et de co-réactif, qui sont séparées par des étapes de purge et de pompage, conduisant à une croissance de couche auto-limitée. Les co-réactifs et les oxydants sont généralement des sources d'oxygène (H₂O ou plasma d'oxygène). Pour obtenir le matériau multicouche, différentes monocouches ALD sont fabriquées, en alternant les pulses de précurseurs.

Selon un mode de réalisation particulier, les précurseurs des oxydes d'hafnium et de zirconium, lors des dépôts par une technique de dépôt de couche atomique, sont des précurseurs halogénés, en particulier HfCl₄ et ZrCl₄ respectivement.

Selon un autre mode de réalisation particulier, des précurseurs organométalliques, comme le TDMAZ (pour Tetrakis-dimethylamino-zirconium-IV) peuvent être utilisés.

Selon un autre mode de réalisation le dispositif multicouches M' est préparé par dépôts successifs des couches A et B, en particulier par une technique de dépôt PVD (pour Physical Vapor Déposition) ou PLD (Pulsed Laser Déposition).

Selon un mode de réalisation particulier, les couches A et/ou B du dispositif multicouche M et/ou du dispositif multicouche M' ont une épaisseur comprise de 0,5 à 5 nm, notamment de 2 nm environ.

Selon un mode de réalisation particulier, les couches A ont une épaisseur comprise de 0,5 à 5 nm, préférentiellement de 2 nm environ, et les couches B ont une épaisseur comprise de 0,5 à 5 nm, préférentiellement de 2 nm environ.

Selon un mode de réalisation particulier, le dispositif multicouche M et/ou le dispositif multicouche M' ont une épaisseur inférieure à 50 nm, notamment inférieure à ou égale à 15 nm, en particulier inférieure à ou égale à 10 ou 6 nm.

Le retrait de l'étape (iv) est réalisable en utilisant les techniques de l'état de l'art comme la gravure ionique réactive au plasma à couplage inductif (ICP-RIE pour Inductively coupled plasma reactive ion etching), en utilisant par exemple une chimie à base de gaz halogéné (Cl₂, BCl₃, CHF₃) en association avec d'autres gaz (Ar, N₂, O₂, He).

D'autres techniques de retrait chimique peuvent être employées, par exemple pour retirer la couche en nitrure de titane, comme le mélange formé par les éléments chimiques d'hydroxyde d'ammoniac (NH₄OH), du peroxyde d'hydrogène H₂O₂ et de l'eau déionisée H₂O chauffé à 60°C.

La gravure de l'étape (v) permet de diminuer l'épaisseur de l'empilement total.

Sans vouloir se restreindre à une quelconque théorie, la gravure des couches A et B lors de l'étape (v) est sélective car elle exploite la différence d'orientation/structure desdites couches A et B. Cette sélectivité n'est au contraire pas obtenue pour un matériau ferroélectrique standard, uniforme et homogène, pour lequel les composants des couches A et B seraient mélangés.

Expérimentalement, et comme bien connu de l'homme du métier, les épaisseurs des structures peuvent être contrôlées en fonction du temps d'immersion ou de gravure et de la composition chimique des liquides utilisés.

Selon un mode de réalisation particulier, la gravure sélective de l'étape (v) est une gravure totale des n' - n couches supérieures, à l'opposé de l'électrode métallique inférieure (200).

Selon un autre mode de réalisation particulier, la gravure sélective de l'étape (v) est partielle (elle n'est donc pas totale). Dans ce cas, une partie ou l'intégralité des n' - n couches supérieures n'est que partiellement gravée et reste présente sur le dispositif M.

Selon un mode de réalisation particulier, la gravure sélective de l'étape (v) est une gravure humide ou sèche, notamment une gravure (ALE), par exemple par plasma (anisotrope), ou thermique (isotrope).

En général, et comme bien connu de l'homme du métier, il existe principalement deux classes de procédés de gravure: la gravure humide où le matériau est dissous lorsqu'il est immergé dans une solution chimique. Et la gravure sèche où le matériau est pulvérisé ou dissous à l'aide d'ions réactifs ou d'un agent de gravure en phase vapeur. Lorsque ledit matériau est dissous, et sans vouloir se restreindre à une quelconque théorie, il s'agit typiquement de la réaction du matériau avec des ions ou autres qui crée des espèces volatiles.

La vitesse à laquelle le processus de gravure se produit est appelée vitesse de gravure. Le processus de gravure est dit isotrope s'il se déroule dans toutes les directions à la même vitesse. S'il se déroule dans une seule direction et dépend fortement de la structure cristalline du matériau, alors il est anisotrope. Une considération importante dans tout processus de gravure est la « sélectivité » de l'agent de gravure. La sélectivité est obtenue lorsque deux matériaux différents ont des vitesses de gravure différentes dans les mêmes conditions ou lorsqu'un matériau grave tandis que l'autre ne grave pas. La sélectivité est mesurée comme le rapport entre les différentes vitesses de gravure de l'agent de gravure pour différents matériaux. La gravure anisotrope est possible grâce aux structures et aux orientations cristallines distinctes des différents matériaux qui composent la structure multicouche. L'exposition à différentes vitesses de gravure ou compositions chimiques est réalisée en fonction de la cristallinité du matériau.

A titre d'exemple, dans le cas d'une structure multicouche de HfO₂ et ZrO₂, une gravure de type « thermal atomic layer etching » (ALE) peut notamment être réalisée en utilisant des réactions de fluoration et d'échange de ligands. Le HF peut par exemple être utilisé pour la fluoration et Sn(acac)₂, AlCl(CH₃)₂ [chlorure de diméthylaluminium (DMAC)] ou TiCl₄ utilisés comme précurseurs métalliques pour l'échange de ligands. La méthode dite « Atomic layer etching » (ALE) est une méthode utilisée pour éliminer des films minces avec une précision de l'ordre de l'Angström à l'aide de réactions de surface séquentielles et auto-limitantes.

Selon un mode de réalisation particulier, l'invention concerne un procédé tel que décrit précédemment, dans lequel :
- La couche A du dispositif M' est à dominante tétragonale ;
- La couche A du dispositif M est à dominante tétragonale.
- La couche B du dispositif M' est à dominante amorphe ;
- La couche B du dispositif M est à dominante orthorhombique et/ou monoclinique.

Par « à dominante amorphe, orthorhombique ou tétragonale », on entend en particulier que la couche est à plus de 50% amorphe, orthorhombique ou tétragonale, respectivement.

Selon un mode de réalisation particulier, une partie de l'étape de recuit (iii) peut être confondue avec l'étape (ii). En effet, et à titre d'exemple, le budget thermique du procédé ALD (400°C pendant 15mn) typiquement nécessaire au dépôt d'une couche d'électrode supérieure en TiN de 10nm peut être suffisant à la cristallisation de la dernière couche A ou B, notamment A.

Le recuit peut être réalisé par toute technique bien connue de l'homme du métier, par exemple un recuit thermique rapide (RTA), ou un recuit à l'aide d'un four, d'une plaque chauffante, assisté par rayonnement, ou à l'aide d'un laser.

Selon un mode de réalisation particulier, le recuit de l'étape (iii) est réalisé à une température de 300 à 600°C, notamment de 300 à 500°C, en particulier à 400°C environ.

Selon un mode de réalisation particulier, l'étape (vi) est réalisée.

Selon un mode de réalisation particulier, l'étape (vi) n'est pas suivie d'étape de recuit.

Selon un mode de réalisation particulier, l'électrode métallique mentionnée relativement à l'étape (ii) et/ou l'électrode métallique mentionnée relativement à l'étape (vi) sont déposées par dépôt physique en phase vapeur (PVD) ou dépôt chimique en phase vapeur (CVD).

Selon un mode de réalisation particulier, l'électrode métallique inférieure mentionnée relativement à l'étape (i) est au contact, à l'opposé de la couche A, d'un substrat.

Selon un mode de réalisation particulier, le substrat est un substrat constitué de ou comprenant du silicium.

Selon un mode de réalisation particulier, l'électrode métallique mentionnée relativement à l'étape (i) est déposée par dépôt physique en phase vapeur (PVD) ou dépôt chimique en phase vapeur (CVD).

Selon un mode de réalisation particulier, l'électrode métallique mentionnée relativement à l'étape (i), l'électrode métallique mentionnée relativement à l'étape (ii) et/ou l'électrode métallique mentionnée relativement à l'étape (vi) sont constituées de ou comprennent un métal notamment choisi parmi titane, or, aluminium platine, ruthénium, molybdène, cuivre, et tungstène, un matériau comprenant ledit métal, notamment un nitrure métallique, par exemple TiN, WN, TaN, ou MoN, ou leurs mélanges.

Selon un mode de réalisation particulier, l'électrode métallique mentionnée relativement à l'étape (i), l'électrode métallique mentionnée relativement à l'étape (ii) et/ou l'électrode métallique mentionnée relativement à l'étape (vi) ont une épaisseur comprise de 2 ou 5 à 500nm, notamment de 2, 5 ou 10 à 100nm, en particulier de 2 ou 5 à 20nm.

Le substrat, ou lorsqu'il est absent, l'électrode métallique inférieure, peut être plan(e) ou non-plan(e). Etant donné que l'ensemble des couches décrites ci-dessus (la au moins une couche A, la au moins une couche B, et lorsqu'elles sont présentes, l'électrode métallique inférieure et/ou l'électrode métallique supérieure) a généralement une épaisseur constante (typiquement une épaisseur étant de ±10%, en particulier de ±1%, de sa valeur moyenne), l'ensemble des couches décrites ci-dessus a la même géométrie structurale que le substrat sur lequel cet ensemble repose, ou lorsqu'il est absent, que l'électrode métallique inférieure sur laquelle il repose.

Selon un autre aspect, la présente invention concerne également un procédé de préparation de structures tridimensionnelles comprenant au moins un dispositif M tel que décrit précédemment, notamment une pluralité de dispositifs M, lequel est préparé selon les étapes telles que décrites précédemment.

Le dispositif M selon l'invention peut être utilisé dans la préparation de capacitances anti-ferroélectriques, notamment dans un dispositif de microélectronique ou de nanoélectronique, par exemple dans le domaine du stockage d'énergie, des mémoires, des transistors.

### Définitions

Tel qu'on l'entend ici, les plages de valeur sous forme de « x-y » ou « de x à y » ou « entre x et y » incluent les bornes x et y, les entiers compris entre ces bornes, ainsi que tous les autres nombres réels compris entre ces bornes. A titre d'exemple, « 1-5 », ou « de 1 à 5 » ou « entre 1 et 5 » désignent les entiers 1, 2, 3, 4 et 5, ainsi que tous les autres nombres réels compris entre 1 et 5. Les modes de réalisations préférés incluent chaque entier pris individuellement dans la plage de valeur, ainsi que toute sous-combinaison de ces entiers et tout ensemble de nombres réels compris entre ces entiers. A titre d'exemple, les valeurs préférées pour « 1-5 » peuvent comprendre les entiers 1, 2, 3, 4, 5, 1-2, 1-3, 1-4, 1-5, 2-3, 2-4, 2-5, etc.

Tel qu'on l'utilise dans la présente description, le terme « environ » se réfère à un intervalle de valeurs de ± 10 % d'une valeur spécifique. A titre d'exemple, l'expression « environ 20 » comprend les valeurs de 20 ± 10 %, soit les valeurs de 18 à 22.

Par couche, on entend notamment une strate d'éléments superposés. Cette strate fait généralement référence à une couche dont les propriétés physico-chimiques et structurales sont uniformes et homogènes, sur le plan et sur sa profondeur.

Par première couche, on entend notamment une couche en contact avec une deuxième couche et, optionnellement, avec un substrat.

Par deuxième couche, on entend notamment une couche en contact avec la première couche et avec, lorsqu'elle existe, la troisième couche.

Par troisième couche, on entend notamment une couche en contact avec la deuxième couche et avec, lorsqu'elle existe, la quatrième couche, et ainsi de suite.

### FIGURES

La figure 1 illustre un dispositif obtenu selon un procédé selon l'invention tel que décrit à l'exemple 1, étape 1.
Les **figure 2****,** **4 et 5** illustrent un dispositif obtenu selon un procédé selon l'invention tel que décrit à l'exemple 1, étape 2.
La **figure 3** illustre le spectre de de diffraction des rayons X en incidence rasante, GIXRD pour Grazing Incident X-ray Diffraction, d'un dispositif tel que décrit à l'exemple 1, étape 2.
Les **figure 6** **et** **7** illustrent un dispositif obtenu selon un procédé selon l'invention tel que décrit à l'exemple 1, étape 3.
Les **figure 8 et 9** illustrent un dispositif obtenu selon un procédé selon l'invention tel que décrit à l'exemple 1, étape 4.

### EXEMPLES

### Exemple 1 : Préparation d'un dispositif selon un procédé de l'invention

### Etape 1 : Réalisation de la couche d'électrode inférieure

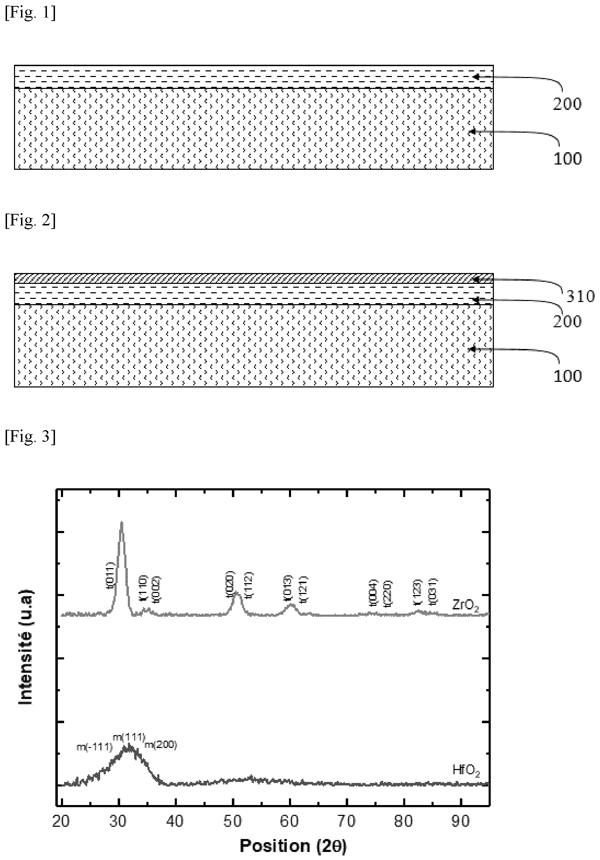

Cette étape schématisée par la figure 1 a trait à la réalisation d'une couche conductrice (200) faisant office d'une électrode inférieure sur un substrat standard généralement en silicium (100). La couche (200) est choisie pour ses propriétés de conduction électrique dans la famille des métaux (Titane, Or, Platine, Aluminium, Tungstène, Ruthénium, Molybdène, Cuivre...) ou des nitrures métalliques (TiN, WN, TaN, MoN...) ou d'un mélange de plusieurs éléments. Dans l'exemple de la figure 1, la couche (200) en nitrure de titane TiN d'une épaisseur de 2 à 20nm, en particulier de10nm, est fabriquée par les techniques de l'état de l'art. En particulier, elle est fabriquée en utilisant le procédé ALD (pour Atomic Layer Déposition) thermique à 400°C en injectant/purgeant de façon séquentielle les précurseurs chimiques TiCl₄ et NH₃. Optionnellement, il est possible de fabriquer la couche TiN 10nm à une température de 200°C en utilisant le mode ALD assisté par plasma et les précurseurs TDMAT (pour tétrakis-diméthylamino-titane) et NH₃. D'autres techniques de dépôt de couches minces (CVD pour Chemical Vapor Déposition, PVD pour Physical Vapor Déposition) connues par l'état de l'art peuvent être employer pour la fabrication de la couche d'électrode inférieure.

### Etape 2 : Réalisation de la couche anti-ferroélectrique

En premier, l'étape 2 schématisée par la figure 2 consiste à déposer par-dessus la couche d'électrode inférieure (200) une couche unitaire (310) d'une épaisseur comprise entre 0,5nm et 10nm. Dans cet exemple de réalisation, l'épaisseur de la couche (310) est fixée à 2 nm. Ladite couche est généralement caractérisée par une structure cristalline. Elle est formée à partir d'un oxyde métallique ou de l'association de plusieurs oxydes métalliques. Préférentiellement, il s'agit d'une couche d'oxyde de zirconium ZrO₂ déposée par ALD thermique à 300°C en utilisant le précurseur ZrCl₄, employé comme réactant métallique, et de l'eau H₂O employée comme oxydant. Optionnellement, des précurseurs organométalliques (comme le TDMAZ pour Tetrakis-dimethylamino-zirconium-IV) ou des techniques alternatives à l'ALD comme la PVD (pour Physical Vapor Déposition) ou la PLD (Pulsed Laser Déposition) peuvent être utilisés pour le dépôt de la couche ZrO₂ permettant d'avoir une phase cristalline dominante après l'étape de dépôt. Une structure cristalline tétragonale de la couche unitaire ZrO₂ (310) peut être définie par la présence des pics caractéristiques selon la représentation graphique GIXRD de la figure 3 (la technique de diffraction des rayons X en incidence rasante, GIXRD pour Grazing Incident X-ray Diffraction : elle est souvent utilisée pour caractériser la structure cristalline des couches minces et ultraminces en mesurant l'intensité d'un faisceau de rayons X par rapport à l'angle de diffraction).

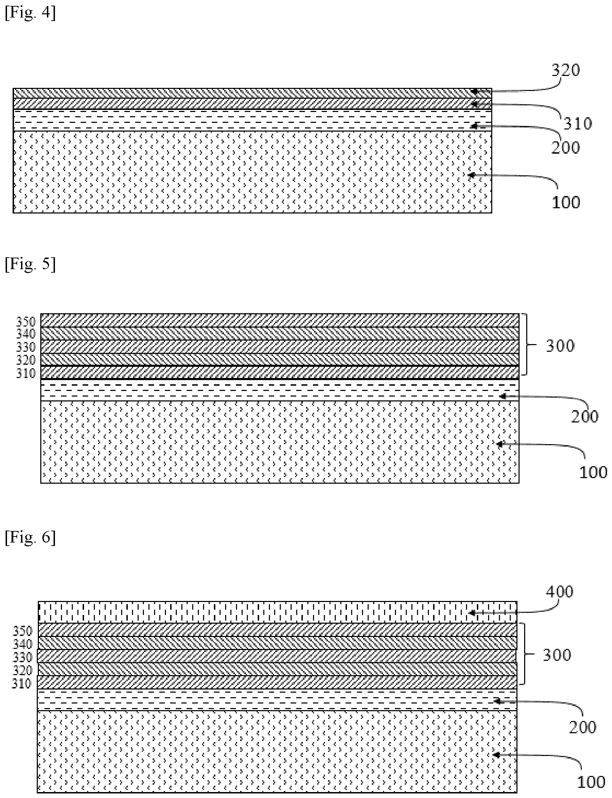

En second, la construction de la couche anti-ferroélectrique nécessite le dépôt d'une deuxième couche unitaire (320) en contact direct avec la couche unitaire (310) selon le schéma de la figure 4. D'une épaisseur comprise entre 0,5 nm et 10nm (et préférentiellement à 2nm), cette deuxième couche (320) présente une structure de maille amorphe ou à dominance amorphe après l'étape de dépôt. Elle est formée à partir d'un oxyde métallique ou de l'association de plusieurs oxydes métalliques. Dans l'exemple de réalisation préférentiel, il s'agit d'une couche d'oxyde d'hafnium HfO₂ déposée par ALD thermique à 300°C en utilisant le précurseur HfCl₄, employé comme réactant métallique, et de l'eau H₂O employée comme oxydant. Optionnellement, des précurseurs organométalliques (comme le TDMAH pour Tetrakis-dimethylamino-hafnium-IV) ou des techniques alternatives à l'ALD comme la PVD (pour Physical Vapor Déposition) ou la PLD (Pulsed Laser Déposition) peuvent être utilisés pour le dépôt de la couche HfO₂ permettant d'avoir une phase amorphe dominante après l'étape de dépôt. Expérimentalement, une couche unitaire est dite amorphe en cas d'absence totale ou d'une présence minime des pics de cristallisation de la structure de maille élémentaire. C'est notamment le cas pour la couche HfO₂ dont les pics caractéristiques après étape de dépôt sont représentés par le spectre de la figure 3.

L'étape 2 de cet exemple de réalisation vise à construire une structure multicouche (300) en utilisant une brique élémentaire de deux matériaux différents notés « A » et « B » dans ce document et correspondant, respectivement, aux couches unitaires (310) et (320). Selon le mode de réalisation préférentiel, les couches unitaires (310) et (320) sont alternées et itérées (3 fois pour la couche 310 et 2 fois pour la couche 320) en respectant l'ordre du schéma de la figure 5 pour avoir un système pentacouche (300). Ainsi, dans notre exemple les couches unitaires (310), (330) et (350) sont identiques d'un point de vue mode technologique de réalisation et propriétés intrinsèques. Il est de même pour les couches unitaires (320) et (340).

### Etape 3 : Formation et retrait de la première couche d'électrode supérieure

Cette étape peut être subdivisée en 2 ou 3 sous étapes : dépôt, éventuellement recuit et retrait. La première permet d'avoir une couche conductrice qui peut être identique ou différente à la couche d'électrode inférieure. Dans cet exemple, le choix est porté sur une couche conductrice (400) en nitrure de titane TiN d'une épaisseur de 2 à 20nm, en particulier de 10nm, dont les propriétés intrinsèques et les modes de réalisation sont identiques à l'électrode inférieure décrite en étape 1. La couche (400) est disposée sur le système pentacouche (300) selon le schéma de la figure 6.

Le dépôt de l'électrode supérieure (400) est suivi par une étape de recuit thermique à 400°C pendant 1h sous atmosphère d'azote. D'autres conditions et modes de recuit compatibles avec la technologie BEOL peuvent être envisagées comme les recuits rapides ou les recuits lasers. L' objectif de l'étape de recuit est de conférer une structure cristalline au système pentacouche (300) sous l'effet conjoint du budget thermique et du stress mécanique induit par la présence de la couche d'électrode supérieure (400). La phase préliminaire de la couche unitaire HfO₂ majoritairement amorphe est de nature à favoriser une transformation vers une phase à dominance monoclinique après l'étape de recuit thermique. L'une des particularités de la présente invention est de pouvoir associer chaque couche unitaire (310, 330, 350) et (320, 340) composant la structure multicouche (300) à une orientation cristalline particulière. Ainsi après l'étape de recuit, les phases majoritaires constatées sont orthogonales et monocliniques, respectivement, pour la couche unitaire (3100, 3300, 3500) en ZrO₂ et la couche unitaire (3200, 3400) en HfO₂.

Le retrait de la couche unitaire (400) est réalisable en utilisant les techniques de l'état de l'art comme la gravure ionique réactive au plasma à couplage inductif (ICP-RIE pour Inductively coupled plasma reactive ion etching) en utilisant une chimie à base de gaz halogéné (Cl₂, BCl₃, CHF₃) en association avec d'autres gaz (Ar, N₂, O₂, He). D'autres techniques de retrait chimique peuvent être employées pour retirer la couche en nitrure de titane comme le mélange formé par les éléments chimiques d'hydroxyde d'ammoniac (NH₄OH), du peroxyde d'hydrogène H₂O₂ et de l'eau déionisée H₂O chauffé à 60°C.

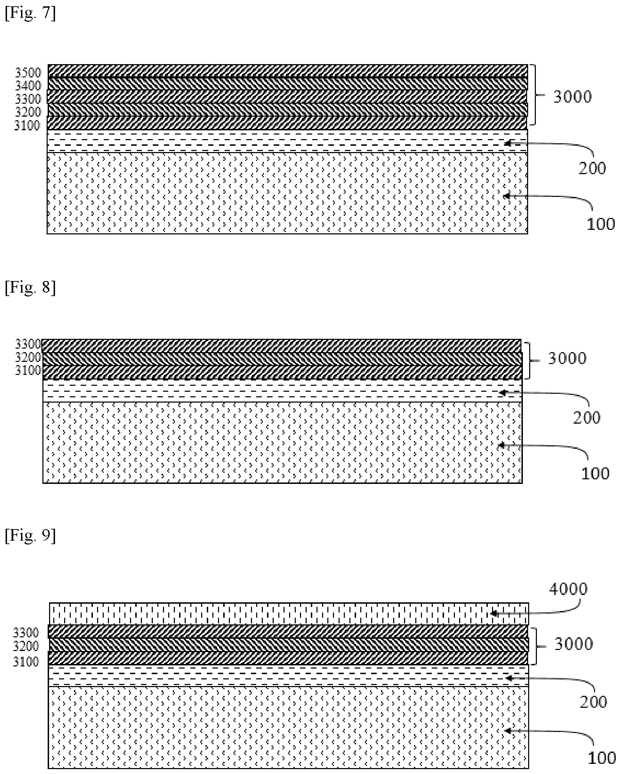

Dans cet exemple de réalisation (figure 7), il est possible de graver une couche (400) de TiN de façon sélective, par rapport à la couche unitaire (3500) en particulier et au système multicouche (3000) en général, en une durée de 60s avec la technique ICP-RIE en utilisant un mélange CHF₃/Ar (30%Ar, un flux de gaz de 120 sccm) à une température de 85°C sous une pression totale de 8 mTorr et une puissance plasma de 1kW.

### Etape 4 : Amincissement de la couche anti-ferroélectrique

L'un des avantages majeurs de la présente invention réside dans l'emploi d'un système multicouche dont les couches unitaires de base (310, 330 et 350 d'un côté définissant le matériau « A » ; et 320 et 340 de l'autre côté définissant le matériau « B ») sont caractérisées par une orientation cristalline très différente. Concrètement à l'issue de l'étape 3, les couches unitaires de départ (310, 330, 350) en ZrO₂ sont cristallines avec une phase majoritaire tétragonale qui reste dominante après l'étape de recuit. En revanche, les couches unitaires en HfO₂ (320, 340) à dominance amorphe sont devenues cristallines avec une phase majoritaire monoclinique et seront notées. Les couches unitaires obtenues après l'opération de recuit seront notées respectivement (3100, 3200, 3300, 3400, 3500) formant ainsi un système multicouche noté (3000) caractérisé par une phase cristalline à dominance tétragonale et/ou orthorhombique.
Le retrait sélectif de la couche (400) permet un accès direct au système multicouche. L'amincissement de la couche anti-ferroélectrique est l'étape permettant de réduire l'épaisseur finale du système multicouche. Selon l'une des configurations (figure 8), l'étape 4 vise à éliminer la couche unitaire (3500) et la couche unitaire (3400) de l'empilement formant le système multicouche initial (3000).
Expérimentalement, l'étape 4 fait appel aux techniques de gravure de couches atomiques ALE (pour Atomic Layer Etching) très adaptées aux couches unitaires ultraminces. Cette technique est basée sur une injection séquentielle des gaz réactifs séparée par des temps de purge selon un nombre de cycle établi en fonction de l'épaisseur de la couche unitaire à retirer. Selon l'un des modes de réalisation, l'élimination sélective des couches unitaires ZrO₂ et HfO₂ emploie une chimie SF₄ (gaz de fluorination modifiant la composition de la couche à retirer) et TiCl₄ (précurseur métallique pour l'échange de ligands et la suppression de la couche souhaitée). Pour une pression de 1 Torr sous un flux de gaz neutre (N₂ ou Ar) et une température fixée à 250°C, il faut considérer environ 50 cycles et 300 cycles de SF₄ (temps exposition 1s et une purge de 30s) et de TiCl₄ (temps exposition 1s et une purge de 30s) pour retirer respectivement et complètement les couches unitaires (350) en ZrO₂ et (340) en HfO₂ d'une épaisseur de 2 nm chacune. Les conditions expérimentales de la gravure ALE sont données à titre d'exemple et dépendent principalement de la nature physico-chimique et cristalline et de l'épaisseur des couches à graver et du type de l'équipement ALE employé.
Alternativement, l'amincissement et le retrait des couches unitaires (3400 et 3500) peut être réalisé de façon sélective dans une solution liquide adaptée vu que les vitesses de gravures des matériaux formants les deux couches unitaires sont sensiblement différentes. A tire d'exemple, la couche unitaire (3500) de ZrO₂ d'une épaisseur de 2nm peut être retirée après 30s d'exposition à une solution d'acide fluorhydrique (HF) concentrée à 2.5% et chauffée à 80°C. En revanche, il faut uniquement 5s d'exposition dans la même solution pour retirer 2 nm de la couche unitaire (3400) en HfO₂.
La résultante de l'étape 4 est un multicouche cristallin (3000) dont les propriétés intrinsèques sont préservées par rapport à la couche (300) formée à l'issue de l'étape 3 (dépôt et recuit thermique). Le multicouche anti-ferroélectrique (3000), proprement dit, avec les propriétés visées est finalement obtenu après les étapes de recuit thermique, de retrait de la première couche d'électrode supérieure et de l'étape d'amincissement. La structure capacitance MAFM de la figure 9 est construite après dépôt d'une nouvelle couche d'électrode supérieure (4000) identique à la couche (400) sans recours à une nouvelle opération de recuit thermique.

## Revendications

1. Procédé de préparation d'un dispositif multicouche M anti-ferroélectrique à n couches, n étant compris de 2 à 100, préférentiellement compris de 2 à 25, constitué de ou comprenant une alternance d'au moins une couche A et d'au moins une couche B,
ladite au moins une couche A étant, indépendamment, constituée de ou comprenant un composé choisi parmi les oxydes de zirconium (ZrO₂), les oxydes d'hafnium et de zirconium (HZO) enrichis en zirconium et les pérovskites,
ladite au moins une couche B étant, indépendamment, constituée de ou comprenant un composé choisi parmi les oxydes d'hafnium (HfO₂), les oxydes d'hafnium et de zirconium (HZO) enrichis en hafnium, les oxydes d'hafnium et de zirconium (HZO) dopés en aluminium, les oxydes d'hafnium et de zirconium (HZO) dopés en lanthane, les oxydes d'hafnium et de zirconium (HZO) dopés en gadolinium, les oxydes d'hafnium et de zirconium (HZO) dopés en yttrium, les oxydes d'hafnium et de zirconium (HZO) dopés en silicium, et les oxydes d'hafnium dopé en silicium (HSO),
ledit procédé comprenant les étapes suivantes :
(i) une étape de préparation sur un substrat ou une électrode métallique inférieure (200) d'un dispositif multicouches M' à n' couches, n' étant compris de 3 à 101, avec n' > n, préférentiellement compris entre 3 et 26, comprenant une alternance desdites couches A et B, la première des n' couches, au contact de l'électrode métallique inférieure (200), étant une couche A,
(ii) une étape de dépôt sur ledit dispositif multicouches M' obtenu à l'issue de l'étape (i), à l'opposé de ladite électrode métallique inférieure, d'une électrode métallique supérieure, (400)
(iii) une étape de recuit du dispositif obtenu à l'issue de l'étape (ii),
(iv) une étape de retrait de l'électrode métallique supérieure (400) du dispositif obtenu à l'issue de l'étape (iii),
(v) une gravure sélective des n' - n couches supérieures, à l'opposé de l'électrode métallique inférieure (200), notamment totale, pour obtenir sur ladite l'électrode métallique inférieure le dispositif multicouches M,
(vi) optionnellement, une étape de dépôt sur ledit dispositif multicouches M' obtenu à l'issue de l'étape (v), à l'opposé de ladite électrode métallique inférieure, d'une électrode métallique supérieure (400).

2. Procédé selon l'une quelconque des revendications précédentes, dans lequel la dernière couche du dispositif multicouches M est une couche A.

3. Procédé selon l'une quelconque des revendications précédentes, dans lequel le dispositif multicouche M' est préparé par dépôts successifs des couches A et B, en particulier par une technique de dépôt de couche atomique (ALD), dans laquelle les précurseurs des oxydes d'hafnium et de zirconium sont notamment des précurseurs halogénés, en particulier HfCl₄ et ZrCl₄ respectivement.

4. Procédé selon l'une quelconque des revendications précédentes, dans lequel les couches A et/ou B du dispositif multicouches M et/ou du dispositif multicouches M' ont une épaisseur comprise de 0,5 à 5 nm, notamment de 2 nm environ.

5. Procédé selon l'une quelconque des revendications précédentes, dans lequel le dispositif multicouches M et/ou le dispositif multicouches M' ont une épaisseur inférieure à 50 nm, notamment inférieure à ou égale à 15 nm, en particulier inférieure à ou égale à 10 ou 6 nm.

6. Procédé selon l'une quelconque des revendications précédentes, dans lequel la gravure sélective de l'étape (v) est une gravure humide ou sèche, notamment une gravure (ALE), par exemple par plasma (anisotrope), ou thermique (isotrope).

7. Procédé selon l'une quelconque des revendications précédentes, dans lequel :
- La couche A du dispositif M' est à dominante tétragonale ;
- La couche A du dispositif M est à dominante tétragonale.
- La couche B du dispositif M' est à dominante amorphe ;
- La couche B du dispositif M est à dominante orthorhombique et/ou monoclinique.

8. Procédé selon l'une quelconque des revendications précédentes, dans lequel le recuit de l'étape (iii) est réalisé à une température de 300 à 600°C, notamment de 300 à 500°C, en particulier à 400°C environ.

9. Procédé selon l'une quelconque des revendications précédentes, dans lequel l'électrode métallique mentionnée relativement à l'étape (ii) et/ou l'électrode métallique mentionnée relativement à l'étape (vi) sont déposées par dépôt physique en phase vapeur (PVD) ou dépôt chimique en phase vapeur (CVD).

10. Procédé selon l'une quelconque des revendications précédentes, dans lequel l'électrode métallique inférieure (200) mentionnée relativement à l'étape (i) est au contact, à l'opposé de la couche A, d'un substrat, en particulier un substrat constitué de ou comprenant du silicium, ladite électrode métallique étant notamment déposée par dépôt physique en phase vapeur (PVD) ou dépôt chimique en phase vapeur (CVD).

11. Procédé selon l'une quelconque des revendications précédentes, dans lequel l'électrode métallique mentionnée relativement à l'étape (i), l'électrode métallique mentionnée relativement à l'étape (ii) et/ou l'électrode métallique mentionnée relativement à l'étape (vi) sont constituées de ou comprennent un métal notamment choisi parmi titane, or, aluminium platine, ruthénium, molybdène, cuivre, et tungstène, un matériau comprenant ledit métal, notamment un nitrure métallique, par exemple TiN, WN, TaN, ou MoN, ou leurs mélanges.

12. Procédé selon l'une quelconque des revendications précédentes, dans lequel l'électrode métallique mentionnée relativement à l'étape (i), l'électrode métallique mentionnée relativement à l'étape (ii) et/ou l'électrode métallique mentionnée relativement à l'étape (vi) ont une épaisseur comprise de 2 ou 5 à 500nm, notamment de 2 ou 10 à 100nm, en particulier de 2 ou 5 à 20nm.
